# EUROPEAN PATENT APPLICATION

(11) **EP 4 040 515 A1**
(43) Date of publication of application: **10.08.2022**
(21) Application number: 20871688.6
(22) Date of filing: 29.09.2020
(51) Int. Cl.: H01L 33/48, H01S 5/022, G02B 6/12, G02B 6/42

(54) **OPTICAL WAVEGUIDE PACKAGE AND LIGHT EMITTING DEVICE**

(30) Priority: 30.09.2019 JP 2019180926; 26.12.2019 JP 2019237069
(71) Applicant: Kyocera Corporation, Kyoto-shi Kyoto 612-8501 (JP)
(72) Inventor: ITAKURA, Yoshiaki, Kyoto-shi, Kyoto 612-8501 (JP)
(74) Representative: Viering, Jentschura & Partner mbB Patent- und Rechtsanwälte
(86) International application number: PCT/JP2020/037009
(87) International publication number: WO 2021/065949

(57) **Abstract**

An optical waveguide package includes a substrate, and an optical waveguide layer on an upper surface of the substrate. The optical waveguide layer includes a cladding and a core in the cladding. The cladding has at least one first recess having a bottom surface and a first inner wall surface surrounding the bottom surface. The first inner wall surface of the at least one first recess is inclined and has an upper side outward from a lower side.

## Description

### FIELD

The present disclosure relates to an optical waveguide package and a light-emitting device.

### BACKGROUND

Known techniques are described in, for example, Patent Literature 1 and Patent Literature 2.

### CITATION LIST

### PATENT LITERATURE

Patent Literature 1: Japanese Unexamined Patent Application Publication No. 61-46911
Patent Literature 2: Japanese Patent No. 457968

### BRIEF SUMMARY

An optical waveguide package according to an aspect of the present disclosure includes a substrate, and an optical waveguide layer on an upper surface of the substrate. The optical waveguide layer includes a cladding and a core in the cladding. The cladding has at least one first recess having a bottom surface and a first inner wall surface surrounding the bottom surface. The first inner wall surface of the at least one first recess is inclined and has an upper side outward from a lower side.

A light-emitting device according to another aspect of the present disclosure includes the above optical waveguide package, and at least one light-emitting element accommodated in the at least one first recess in the optical waveguide package.

### BRIEF DESCRIPTION OF DRAWINGS

FIG. 1 is an exploded perspective view of a light-emitting device including an optical waveguide package according to a first embodiment of the present disclosure.
FIG. 2 is a perspective view of the light-emitting device in FIG. 1 without showing a lid.
FIG. 3 is a cross-sectional view of the light-emitting device taken along section line III-III in FIG. 2.
FIG. 4 is an enlarged cross-sectional view of a first recess.
FIG. 5 is a plan view of the first recess in FIG. 4 as viewed from above.
FIG. 6 is an enlarged cross-sectional view of a first recess in a light-emitting device according to a second embodiment of the present disclosure.
FIG. 7 is a plan view of the light-emitting device in FIG. 6.
FIG. 8 is a cross-sectional view of a light-emitting device according to a third embodiment of the present disclosure.
FIG. 9 is a cross-sectional view of the light-emitting device in FIG. 6.
FIG. 10 is a plan view of a light-emitting device according to a fourth embodiment of the present disclosure.
FIG. 11 is a plan view of a light-emitting device according to a fifth embodiment of the present disclosure.
FIG. 12 is a plan view of a light-emitting device according to a sixth embodiment of the present disclosure.
FIG. 13 is a cross-sectional view of the light-emitting device in FIG. 12.
FIG. 14 is an exploded perspective view of a light-emitting device according to a seventh embodiment of the present disclosure.
FIG. 15 is a perspective view of the light-emitting device in FIG. 14 without showing a lid.
FIG. 16 is a cross-sectional view of the light-emitting device taken along section line XVI-XVI in FIG. 14.
FIG. 17 is a plan view of the light-emitting device in each of FIGs. 14 to 16.
FIG. 18 is an enlarged cross-sectional view of a recess in an optical waveguide package according to an eighth embodiment of the present disclosure.
FIG. 19 is an enlarged cross-sectional view of a recess in an optical waveguide package according to a ninth embodiment of the present disclosure.
FIG. 20 is an enlarged cross-sectional view of a recess in an optical waveguide package according to a tenth embodiment of the present disclosure.
FIG. 21 is an enlarged cross-sectional view of a recess in an optical waveguide package according to an eleventh embodiment of the present disclosure.
FIG. 22 is an enlarged cross-sectional view of a recess in an optical waveguide package according to a twelfth embodiment of the present disclosure.
FIG. 23 is an enlarged cross-sectional view of a recess in an optical waveguide package according to a thirteenth embodiment of the present disclosure.
FIG. 24 is an enlarged cross-sectional view of a recess in an optical waveguide package according to a fourteenth embodiment of the present disclosure.
FIG. 25 is an enlarged cross-sectional view of a recess in an optical waveguide package according to a fifteenth embodiment of the present disclosure.
FIG. 26 is an enlarged cross-sectional view of a recess in an optical waveguide package according to a sixteenth embodiment of the present disclosure.
FIG. 27 is an enlarged cross-sectional view of a recess in an optical waveguide package according to a seventeenth embodiment of the present disclosure.

### DETAILED DESCRIPTION

An optical waveguide package and a light-emitting device including the optical waveguide package with the structure that forms the basis of an optical waveguide package according to one or more aspects of the present disclosure are described in, for example, Patent Literature 1. The structure that forms the basis of an optical waveguide package according to one or more aspects of the present disclosure includes a quartz glass optical waveguide located on a silicon substrate, light-emitting and light-receiving elements optically coupled to different end faces of the optical waveguide and bonded onto the silicon substrate, and an optical fiber connected to another end face of the optical waveguide.

The optical waveguide, the light-emitting and light-receiving elements, and the optical fiber are positioned to have their optical axes aligned with one another with the light-emitting and light-receiving elements and the optical fiber in contact with the end faces of the optical waveguide. The light-emitting and light-receiving elements and the optical fiber each have a dimension corresponding to the thickness of the optical waveguide and are thus positioned vertically relative to the silicon substrate. The structure that forms the basis of an optical waveguide package according to one or more aspects of the present disclosure is to include smaller components and allow easier positioning.

An optical waveguide package and a light-emitting device including the optical waveguide package with the structure that forms the basis of another optical waveguide package according to one or more aspects of the present disclosure are described in, for example, Patent Literature 2. The structure that forms the basis of an optical waveguide package according to one or more aspects of the present disclosure includes a gas barrier optical waveguide including a non gas-barrier core and a non gas-barrier cladding coated with a gas barrier thin film, a gas barrier cap, an optical element including a light receiver or a light receiver mounted on the optical waveguide at a position to be optically coupled to the core, and a metal wiring member electrically connected to the optical element on the optical waveguide. In the known structure, the thin film on the optical waveguide and the cap are joined together with a gas barrier inorganic material layer in between. A space for accommodating one end of the core and the optical element can thus be defined and airtightly sealed by gas barrier members alone.

The structures described in Patent Literatures 1 and 2 that form the basis of an optical waveguide package according to one or more aspects of the present disclosure include no structure that can accommodate thermal expansion of the light-emitting and light-receiving elements. Thermal expansion of the light-emitting and light-receiving elements may cause misalignment of the optical axis between the optical waveguide, the light-emitting and light-receiving elements, and the optical fiber, or may cause deformation or damage of the light-emitting and light-receiving elements and components in contact with these elements.

An optical waveguide package according to one or more embodiments of the present disclosure and a light-emitting device including the optical waveguide package will now be described with reference to the drawings.

### First Embodiment

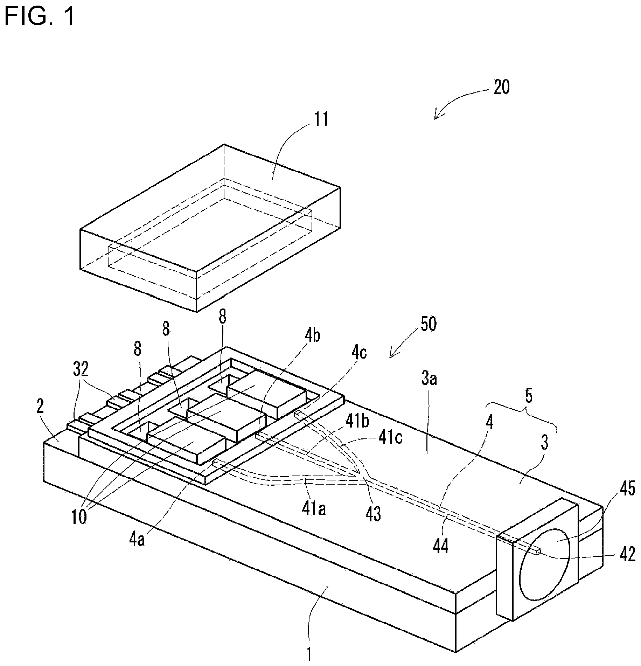

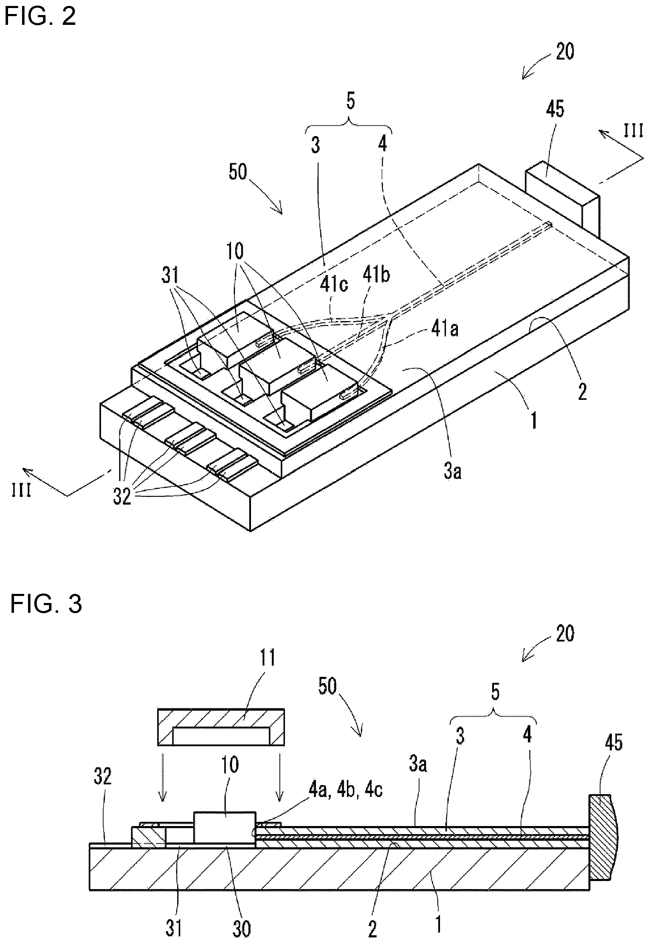

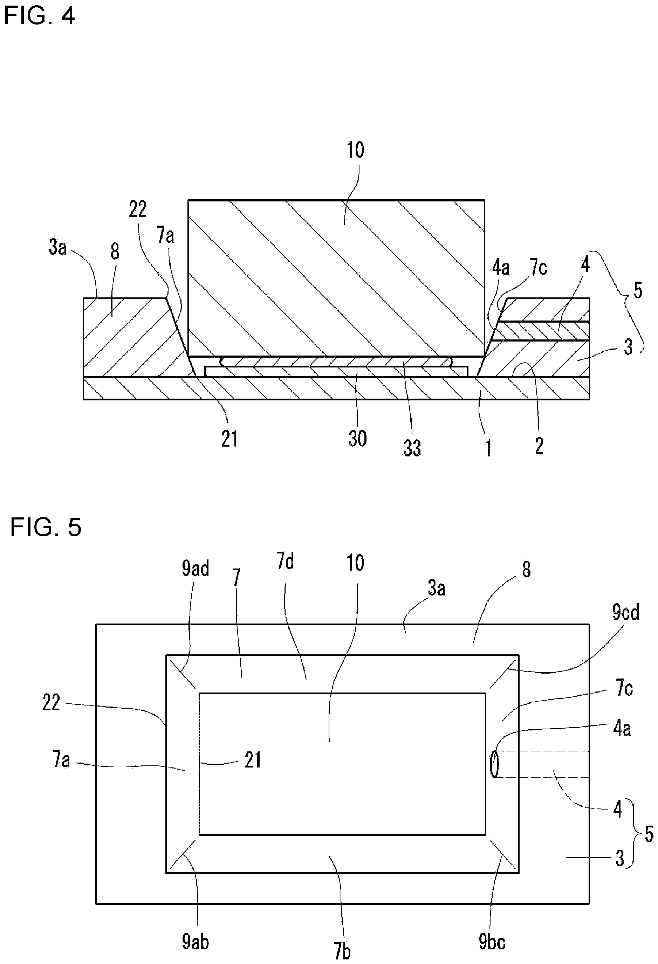

An optical waveguide package 50 shown in FIGs. 1 to 5 includes a substrate 1 and an optical waveguide layer 5. The optical waveguide layer 5 is on an upper surface 2 of the substrate 1 and includes a cladding 3 and a core 4 in the cladding 3. The cladding 3 has multiple first recesses 8 each having a bottom surface 6 and a first inner wall surface 7 surrounding the bottom surface 6. The first inner wall surface 7 is inclined and has an upper side 22 outward from a lower side 21. The first recesses 8 each define an element-receiving portion. A lid 11 is placed to cover the first recesses 8.

The optical waveguide package 50 according to the present embodiment has multiple first recesses 8 each accommodating a light-emitting element 10. The optical waveguide package 50 and the light-emitting elements 10 form a light-emitting device 20. The light-emitting elements 10 may be laser diodes. The optical waveguide layer 5 includes the core 4 and the cladding 3 integral with each other. The substrate 1 may include multiple dielectric layers stacked on one another. The optical waveguide package 50 may have three first recesses 8 for three light-emitting elements 10 for red (R) light, green (G) light, and blue (B) light. Each first recess 8 may receive one light-emitting element 10.

The substrate 1 may be a ceramic wiring board including dielectric layers containing a ceramic material. Examples of the ceramic material used for the ceramic wiring board include sintered aluminum oxide, sintered mullite, sintered silicon carbide, sintered aluminum nitride, and sintered glass ceramic. For the substrate 1 being a ceramic wiring board, the dielectric layers may include conductors such as connection pads 30, internal wiring conductors 31, and external connection terminals 32 for electrical connection between the light-emitting elements 10 (or light-receiving elements) and an external circuit. The light-emitting elements 10 may include electrodes connected to the connection pads 30 using a bond 33.

The substrate 1 may be an organic wiring board including dielectric layers containing an organic material. The organic wiring board may be a printed wiring board, a build-up wiring board, or a flexible wiring board. Examples of the organic material used for the organic wiring board include an epoxy resin, a polyimide resin, a polyester resin, an acrylic resin, a phenolic resin, and a fluororesin.

The optical waveguide layer 5 may be glass such as quartz, or a resin. In the optical waveguide layer 5, both the core 4 and the cladding 3 may be formed from glass or a resin. In this case, the core 4 has a higher refractive index than the cladding 3. The difference in the refractive index causes total internal reflection of light. More specifically, a material with a higher refractive index is used to form a path, which is then surrounded by a material with a lower refractive index. This structure confines light in the core 4 with the higher refractive index.

The core 4 has multiple incident end faces 4a, 4b, and 4c and one emission end face 42. The core 4 defines a merging path including multiple branching paths 41a, 41b, and 41c, a merging portion 43, and a joined path 44 between the incident end faces 4a, 4b, and 4c and the emission end face 42. The branching paths 41a, 41b, and 41c respectively have the incident end faces 4a, 4b, and 4c at one end. The merging portion 43 merges the branching paths 41a, 41b, and 41c together. The joined path 44 has the emission end face 42 at one end. The core 4 may have the incident end faces 4a, 4b, and 4c each having an exposed portion.

The device may include multiple condenser lenses 45 for the respective incident end faces 4a, 4b, and 4c. The condenser lens 45 is located opposite to the incident end faces 4a, 4b, and 4c of the core 4. The condenser lens 45 has an optical axis aligned with the central axis of each of the incident end faces 4a, 4b, and 4c.

Red light, green light, and blue light emitted from the respective light-emitting elements 10 enter the respective branching paths 41a, 41b, and 41c through the incident end faces 4a, 4b, and 4c and pass through the merging portion 43 and the joined path 44 to the condenser lens 45, through which the light is condensed and emitted.

The condenser lens 45 is, for example, a plano-convex lens with a flat incident surface and a convex emission surface. The optical waveguide layer 5, the light-emitting elements 10, and the condenser lens 45 are assembled together to have the branching paths 41a, 41b, and 41c each with its optical axis aligned with the center of the light emitter of the corresponding light-emitting element 10.

Each first recess 8 has the first inner wall surface 7 including multiple wall surfaces 7a, 7b, 7c, and 7d and corner support surfaces 9ab, 9bc, 9cd, and 9ad. The corner support surfaces 9ab, 9bc, 9cd, and 9ad are each located between a first wall surface and a second wall surface of the wall surfaces 7a, 7b, 7c, and 7d adjacent to each other. The wall surfaces 7a, 7b, 7c, and 7d and the corner support surfaces 9ab, 9bc, 9cd, and 9ad are each inclined and have an upper side outward from a lower side. In other words, each first recess 8 has the wall surfaces 7a, 7b, 7c, and 7d and the corner support surfaces 9ab, 9bc, 9cd, and 9ad inclined outward toward the opening of the first recess 8. The corner support surfaces 9ab, 9bc, 9cd, and 9ad support the external corners of a light-emitting element 10, thus reducing misalignment or misorientation of the light-emitting element 10. The optical waveguide layer may thermally expand with heat from the light-emitting elements in use. The optical waveguide package 50 with the above structure reduces the contact area and thus reduces damage to the cladding 3 from, for example, thermal expansion. The optical waveguide package 50 with the above structure allows light to be efficiently coupled to the optical waveguide layer 5. The cross section of the device taken in the thickness direction can show whether the surfaces are inclined.

### Second Embodiment

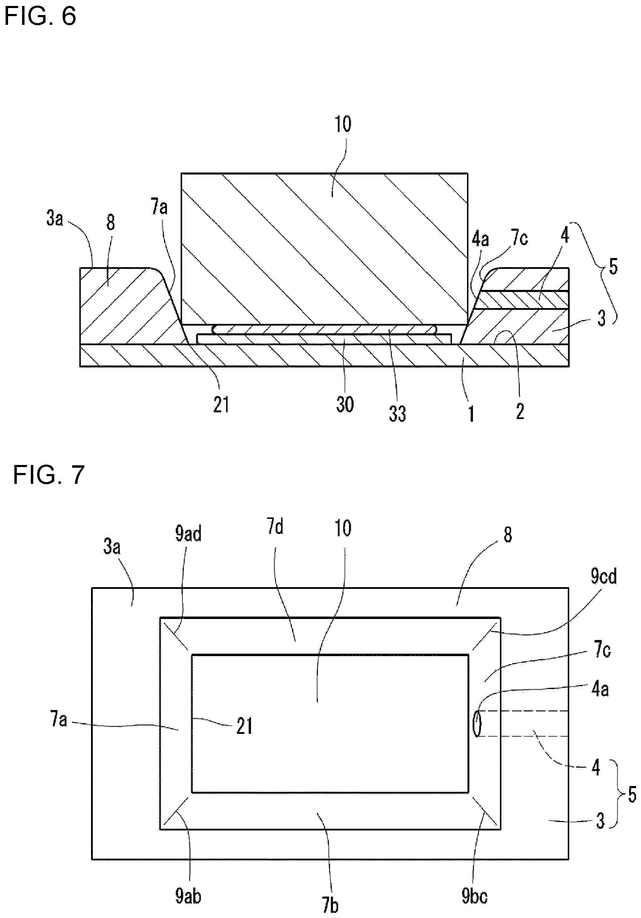

FIGs. 6 and 7 show a light-emitting device according to a second embodiment of the present disclosure. The components corresponding to those in the above embodiments are given the same reference numerals and will not be described repeatedly. Each first recess 8, or an element-receiving portion, may have the opening with a curved edge (or a surface convex inside) as shown in section in FIG. 6. This can reduce damage from, for example, cracks in the inclined surfaces under thermal stress. The above structure can also reduce the reflection of stray light from the light-emitting elements 10. Being inside herein refers to being toward the inner wall of the first recess 8. Being outside herein refers to being toward the outer wall of the first recess 8.

### Third Embodiment

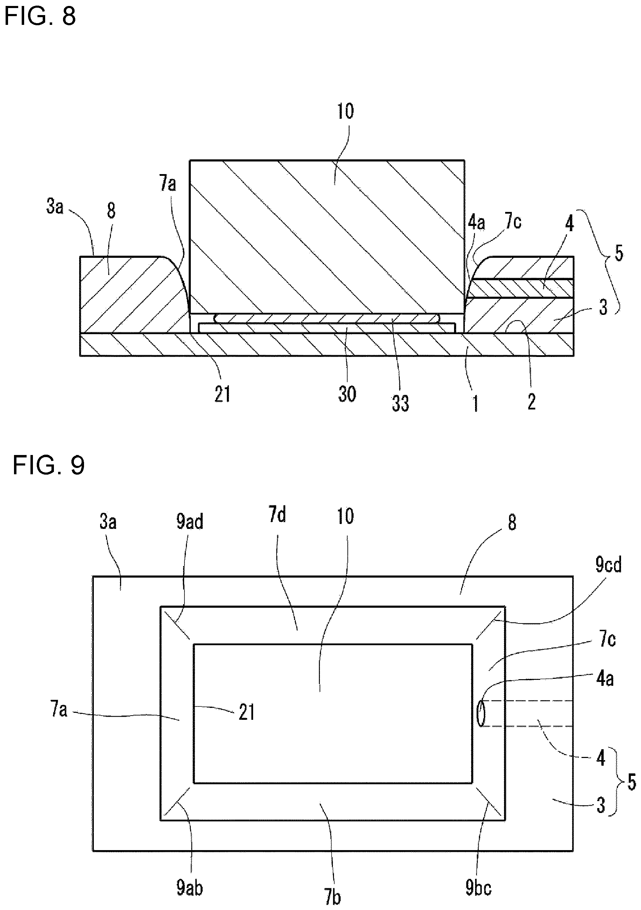

FIGs. 8 and 9 show a light-emitting device according to a third embodiment of the present disclosure. The components corresponding to those in the above embodiments are given the same reference numerals and will not be described repeatedly. Each first recess 8, or an element-receiving portion, may have convex corner support surfaces 9ab, 9bc, 9cd, and 9ad. This can reduce damage from, for example, cracks in the inclined surfaces under thermal stress. The core 4 having end faces convex inside allows light from the light-emitting elements 10 to easily enter the core 4. The wall surfaces 7a, 7b, 7c, and 7d may also be convex.

### Fourth Embodiment

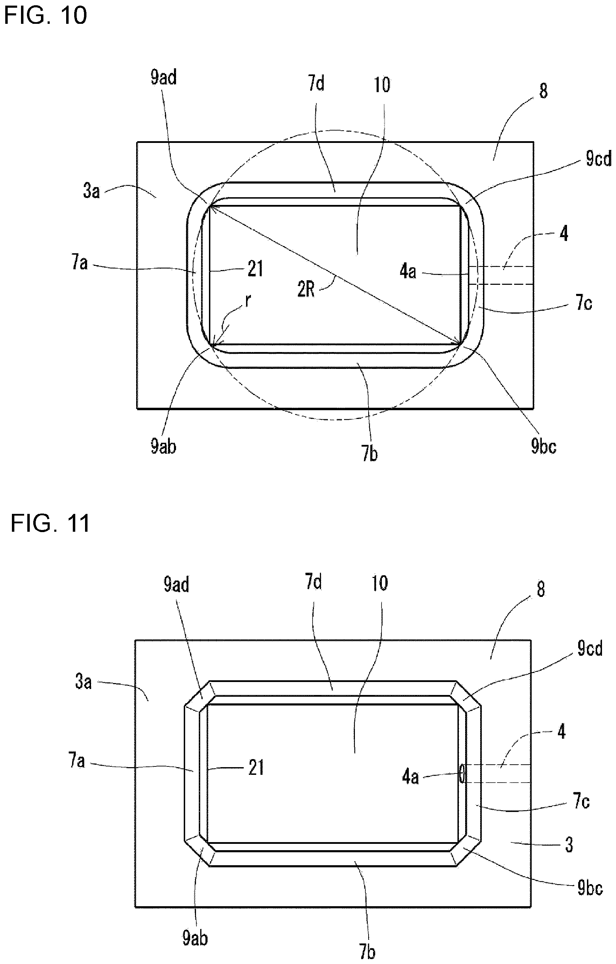

FIG. 10 shows a light-emitting device according to a fourth embodiment of the present disclosure. The components corresponding to those in the above embodiments are given the same reference numerals and will not be described repeatedly. An arc of a circle circumscribed on a light-emitting element 10, or in other words, a circle with its diameter being a diagonal 2R of a light-emitting element 10, is defined imaginarily in a plan view. The corner support surfaces 9ab, 9bc, 9cd, and 9ad may be curved (concave inside, or in other words, convex outside). The optical waveguide with this structure has the corner support surfaces 9ab, 9bc, 9cd, and 9ad in point contact with the lower edges of the light-emitting element 10, allowing a small contact area. This relaxes stress on the light-emitting element 10 caused by thermal expansion. The corner support surfaces 9ab, 9bc, 9cd, and 9ad each may have a curvature radius r smaller than R to support the light-emitting element 10 without being misoriented on the sidewalls of the optical waveguide. The corner support surfaces 9ab, 9bc, 9cd, and 9ad concave in a plan view can reduce damage from, for example, deformation and cracks in the sidewalls under thermal stress.

### Fifth Embodiment

FIG. 11 shows a light-emitting device according to a fifth embodiment of the present disclosure. The components corresponding to those in the above embodiments are given the same reference numerals and will not be described repeatedly. The corner support surfaces 9ab, 9bc, 9cd, and 9ad in the wall surfaces 7a, 7b, 7c, and 7d may be flat in a plan view. The flat corner support surfaces 9ab, 9bc, 9cd, and 9ad can be in point contact with and support the light-emitting element 10. This reduces misorientation of the light-emitting element 10, similarly with the curved corner support surfaces 9ab, 9bc, 9cd, and 9ad. The boundaries between the wall surfaces 7a, 7b, 7c, and 7d and the corner support surfaces 9ab, 9bc, 9cd, and 9ad may be curved. This reduces damage from, for example, deformation and cracks in the wall surfaces 7a, 7b, 7c, and 7d under thermal stress.

### Sixth Embodiment

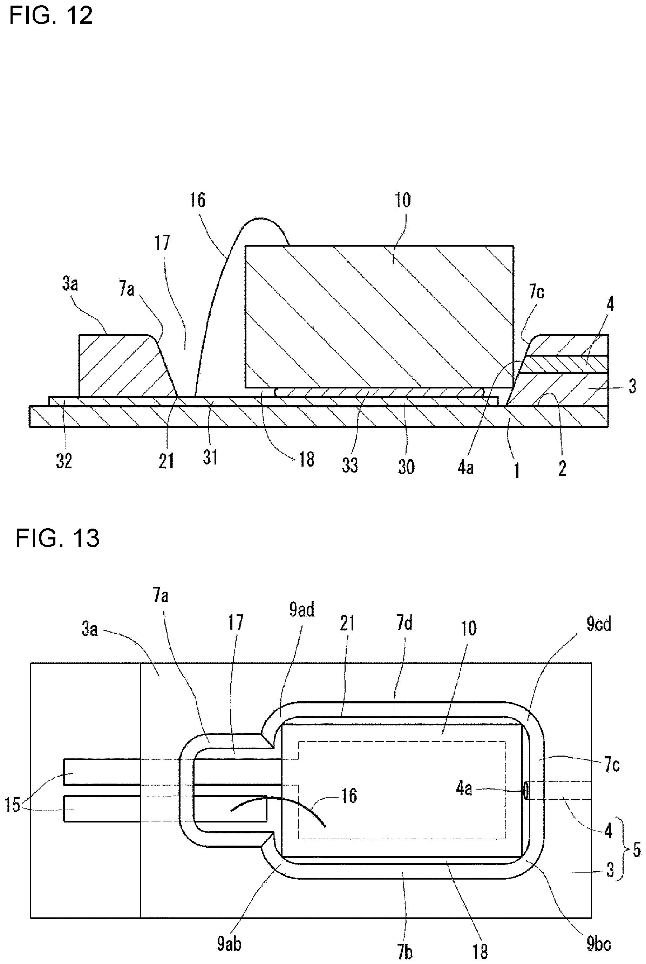

FIGs. 12 and 13 show a light-emitting device according to a sixth embodiment of the present disclosure. The components corresponding to those in the above embodiments are given the same reference numerals and will not be described repeatedly. The light-emitting device includes additional spaces protruding and continuous with the wall surfaces 7a, 7b, 7c, or 7d other than the corner support surfaces 9ab, 9bc, 9cd, and 9ad. The additional spaces can accommodate electrodes for power supply with the light-emitting elements 10 being supported. The additional spaces are referred to as second spaces 17. The spaces to accommodate the light-emitting elements 10 are referred to as first spaces 18. The light-emitting elements 10 can be electrically connected to the electrodes with metal wiring members. Each second space 17 may have wall surfaces 7a, 7b, 7c, and 7d inclined to define a larger opening. The larger opening allows the metal wiring members and collets for connecting the wiring members to avoid contacting the sidewalls and reduces failures caused by, for example, wire breakage.

### Seventh Embodiment

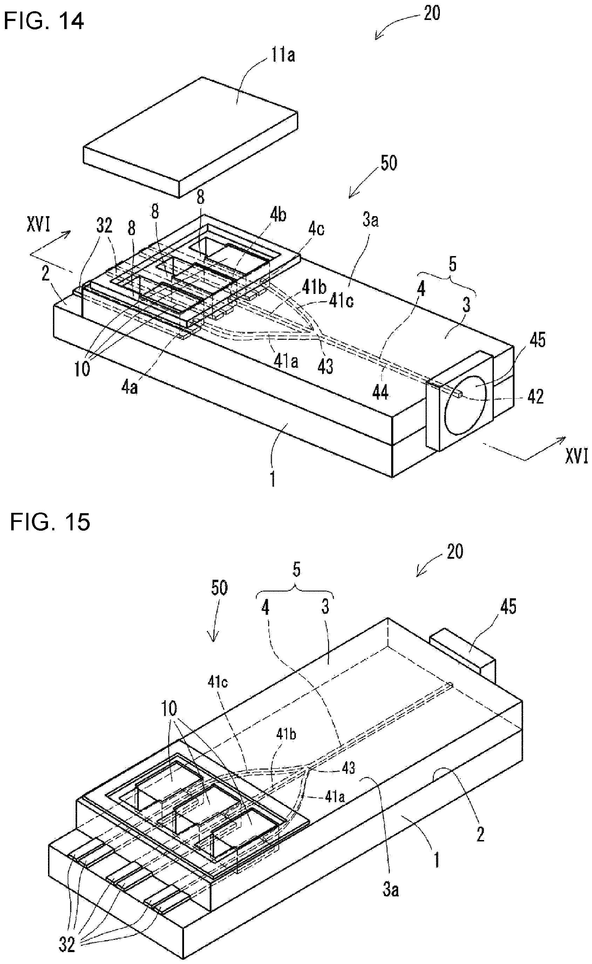

FIGs. 14 to 17 show a light-emitting device according to a seventh embodiment of the present disclosure. The components corresponding to those in the above embodiments are given the same reference numerals and will not be described repeatedly. In the above embodiments, the light-emitting elements 10 include upper portions protruding from the first recesses 8. The protruding portions are covered with the box-shaped lid 11. In another embodiment, the first recesses 8 may each accommodate the entire light-emitting element 10 and may be covered and sealed with a plate-like lid 11a. The optical waveguide package 50 with this structure simplifies the lid 11a.

### Eighth Embodiment

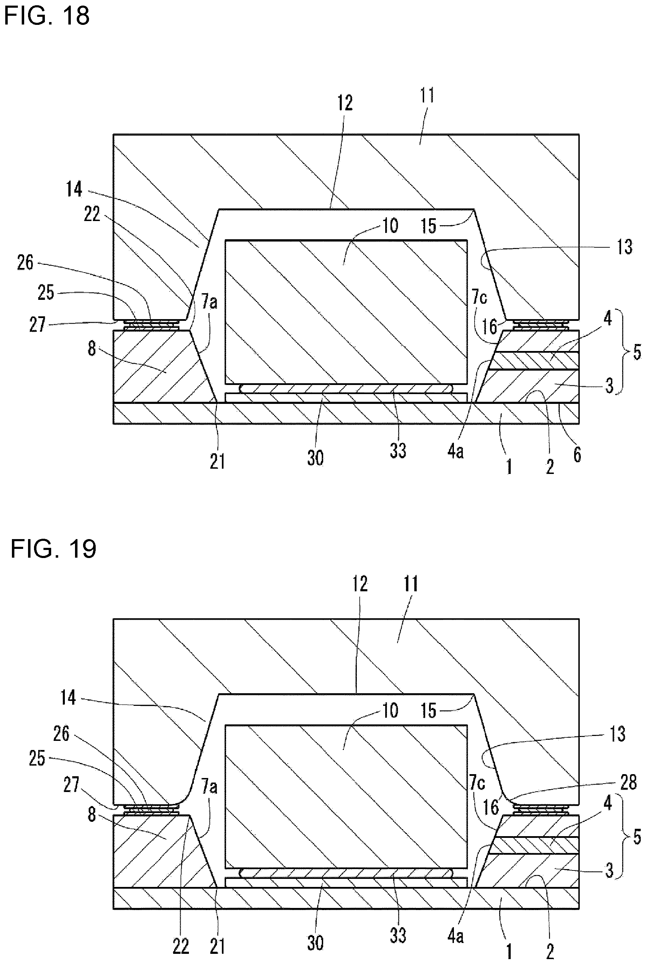

FIG. 18 shows a recess in an optical waveguide package according to an eighth embodiment of the present disclosure. The components corresponding to those in the above embodiments are given the same reference numerals and will not be described repeatedly. First recesses 8 or second recesses 14 may be simply referred to as recesses. Alight-emitting device 20 according to the present embodiment includes a substrate 1 and an optical waveguide layer 5. The optical waveguide layer 5 is on an upper surface 2 of the substrate 1 and includes a cladding 3 and a core 4 in the cladding 3. The cladding 3 has multiple first recesses 8 each having a bottom surface 6 and a first inner wall surface 7 surrounding the bottom surface 6. The first inner wall surface 7 is inclined and has an upper side 22 outward from a lower side 21. The first recesses 8 each define an element-receiving portion. A lid 11 is placed to cover the first recesses 8. The lid 11 may be formed from the same material as the cladding 3, such as glass (e.g., quartz) or a resin.

The lid 11 may have a second recess 14 having a top surface 12 facing the bottom surface 6 of the cladding 3, and a second inner wall surface 13 surrounding the top surface 12. The second inner wall surface 13 is inclined and has a lower side 16 outward from an upper side 15. The lid 11 has a first surface 27 outward from the lower side 16 of the second inner wall surface 13. The first surface 27 defines the mounting surface to be mounted on an upper surface 3a of the cladding 3.

Agas barrier layer 25 is formed on the upper surface 3a of the cladding 3 to surround the opening of each first recess 8 by, for example, plasma-enhanced chemical vapor deposition (CVD) or sputtering. The lid 11 is j oined to the gas barrier layer 25 with a bond 26 to airtightly seal the space accommodating the light-emitting elements 10. The gas barrier layer 25 may be formed from an inorganic material mainly containing, for example, silicic acid, silicon nitride, silicon oxynitride, aluminum oxide, or diamond-like carbon. The gas barrier layer 25 allows the space accommodating the light-emitting elements 10 to be more airtight than using the bond 26 alone to join the lid 11 to the upper surface 3a of the cladding 3. The gas barrier layer 25 also reduces entry of moisture or other external substances into the space. This reduces operation failures of the light-emitting elements 10 caused by moisture or other substances and allows the optical waveguide package to be reliable.

In the present embodiment, the lid 11 has the second inner wall surface 13 inclined outward from the upper side 15 to the lower side 16. The optical waveguide layer 5 and the lid 11 joined together define an internal space hexagonal in cross section, or in other words, in the shape of a polygonal prism close to a cylinder. This structure has a stress distribution with smaller variations in stress and is thus less likely to deform. The first inner wall surface 7 and the second inner wall surface 13 adjacent to each other in the circumferential direction are inclined to form a corner with an obtuse angle. This reduces cracks caused by thermal expansion and contraction and thus reduces breakage and deformation resulting from cracks.

### Ninth Embodiment

FIG. 19 shows a recess in an optical waveguide package according to a ninth embodiment of the present disclosure. The components corresponding to those in the above embodiments are given the same reference numerals and will not be described repeatedly. In a light-emitting device 20 according to the present embodiment, the lid 11 has a first surface 27 outward from the lower side 16 of the second inner wall surface 13, and a second surface 28 convex inside between the first surface 27 and the lower side 16 of the second inner wall surface 13.

The light-emitting device 20 with this structure includes the lid 11 having a curved inner edge, and thus reduces damage from, for example, cracks in the lid 11 under thermal stress. This also reduces misalignment between the incident end faces 4a to 4c of the core 4 and light from the emission portions of the light-emitting elements 10 caused by thermal expansion of the optical waveguide layer 5, thus allowing efficient optical coupling.

### Tenth Embodiment

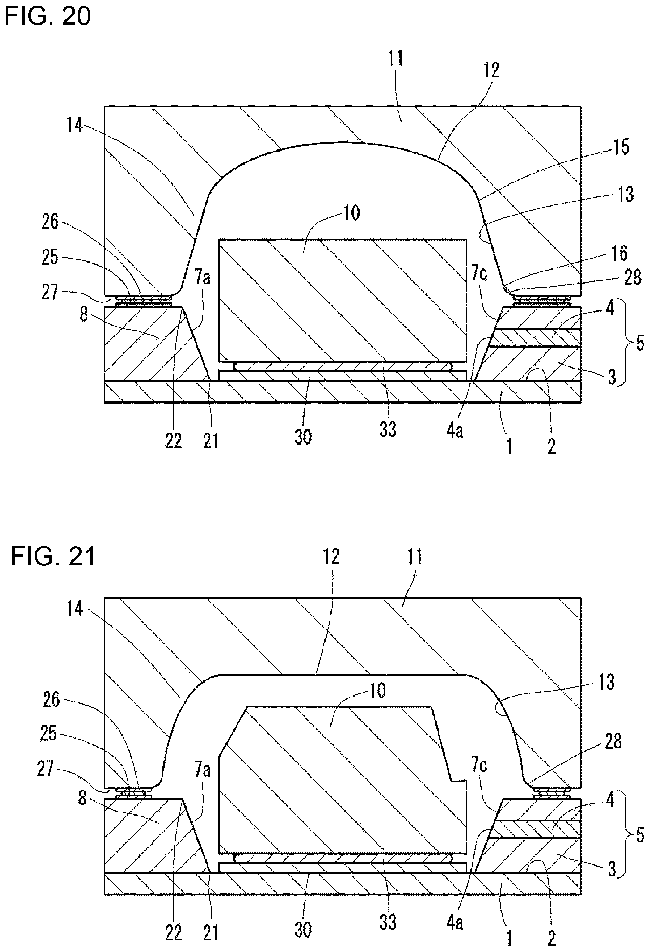

FIG. 20 shows a recess in an optical waveguide package according to a tenth embodiment of the present disclosure. The components corresponding to those in the above embodiments are given the same reference numerals and will not be described repeatedly. In a light-emitting device 20 according to the present embodiment, the top surface 12 is concave inside, the second inner wall surface 13 is flat, and the second surface 28 is convex inside between the first surface 27 and the lower side 16 of the second inner wall surface 13.

The light-emitting device 20 with this structure includes the lid 11 having the curved second inner wall surface 13. This reduces deformation of the optical waveguide layer 5 under thermal stress and also reduces damage from, for example, cracks at the joint interface between the lid 11 and the cladding 3. This also reduces misalignment between the incident end faces 4a to 4c of the core 4 and light from the emission portions of the light-emitting elements 10 caused by thermal expansion, thus allowing efficient optical coupling.

### Eleventh Embodiment

FIG. 21 shows a recess in an optical waveguide package according to an eleventh embodiment of the present disclosure. The components corresponding to those in the above embodiments are given the same reference numerals and will not be described repeatedly. In a light-emitting device 20 according to the present embodiment, the top surface 12 is flat, the second inner wall surface 13 is concave inside, and the second surface 28 is convex inside between the first surface 27 and the lower side 16 of the second inner wall surface 13.

The light-emitting device 20 with this structure includes the lid 11 having the curved second inner wall surface 13. This reduces deformation of the optical waveguide layer 5 under thermal stress and also reduces damage from, for example, cracks at the joint interface between the lid 11 and the cladding 3. This also reduces misalignment between the incident end faces 4a to 4c of the core 4 and light from the emission portions of the light-emitting elements 10 caused by thermal expansion, thus allowing efficient optical coupling.

### Twelfth Embodiment

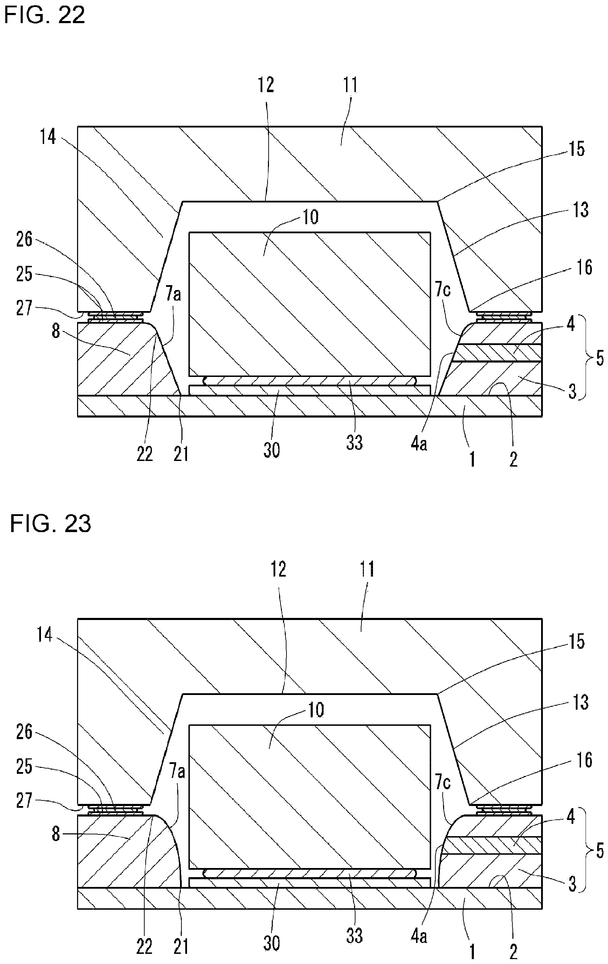

FIG. 22 shows a recess in an optical waveguide package according to a twelfth embodiment of the present disclosure. The components corresponding to those in the above embodiments are given the same reference numerals and will not be described repeatedly. In a light-emitting device 20 according to the present embodiment, the optical waveguide layer 5 further includes a lid 11 located over the first recesses 8 and covering the openings of the first recesses 8. The lid 11 has a second recess 14 having a top surface 12 facing the bottom surface 6, and a second inner wall surface 13 surrounding the top surface 12. The second inner wall surface 13 is inclined and has a lower side 16 outward from an upper side 15. Each first recess 8 has a first inner wall surface 7 including wall surfaces 7a to 7d concave inside.

The light-emitting device 20 with this structure has the first recesses 8, or element-receiving portions, each having an opening defined by a curved edge. This reduces damage from, for example, cracks in the inclined first inner wall surfaces 7 under thermal stress. This also reduces misalignment of the core 4 caused by thermal expansion, thus allowing efficient optical coupling.

### Thirteenth Embodiment

FIG. 23 shows a recess in an optical waveguide package according to a thirteenth embodiment of the present disclosure. The components corresponding to those in the above embodiments are given the same reference numerals and will not be described repeatedly. In a light-emitting device 20 according to the present embodiment, the optical waveguide layer 5 further includes a lid 11 located over the first recesses 8 and covering the openings of the first recesses 8. The lid 11 has a second recess 14 having a top surface 12 facing the bottom surface 6, and a second inner wall surface 13 surrounding the top surface 12. The second inner wall surface 13 is inclined and has a lower side 16 outward from an upper side 15. Each first recess 8 has a first inner wall surface 7 including wall surfaces 7a to 7d concave inside from an upper side 22 to a lower side 21.

The light-emitting device 20 with this structure includes the optical waveguide layer 5 having the curved first inner wall surfaces 7. This reduces cracks or other damage in the first inner wall surfaces 7 under thermal stress. This also reduces misalignment of the core 4 caused by thermal expansion, thus allowing efficient optical coupling. The core 4 has the incident end faces 4a to 4c curved to serve as lenses. This allows light from the light-emitting elements 10 to easily enter the core 4. The light-emitting device 20 with this structure causes less light to diffuse outside the core 4.

### Fourteenth Embodiment

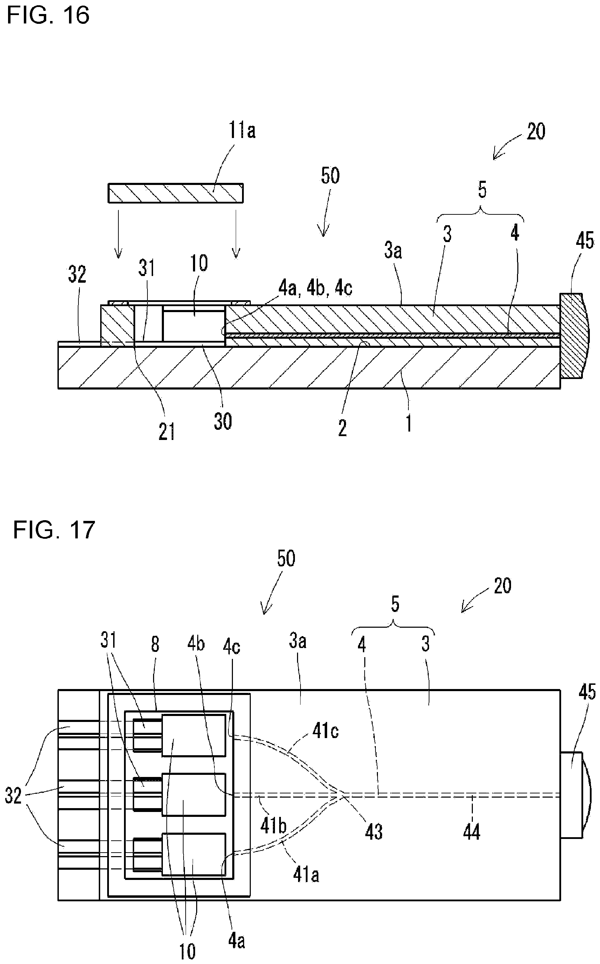

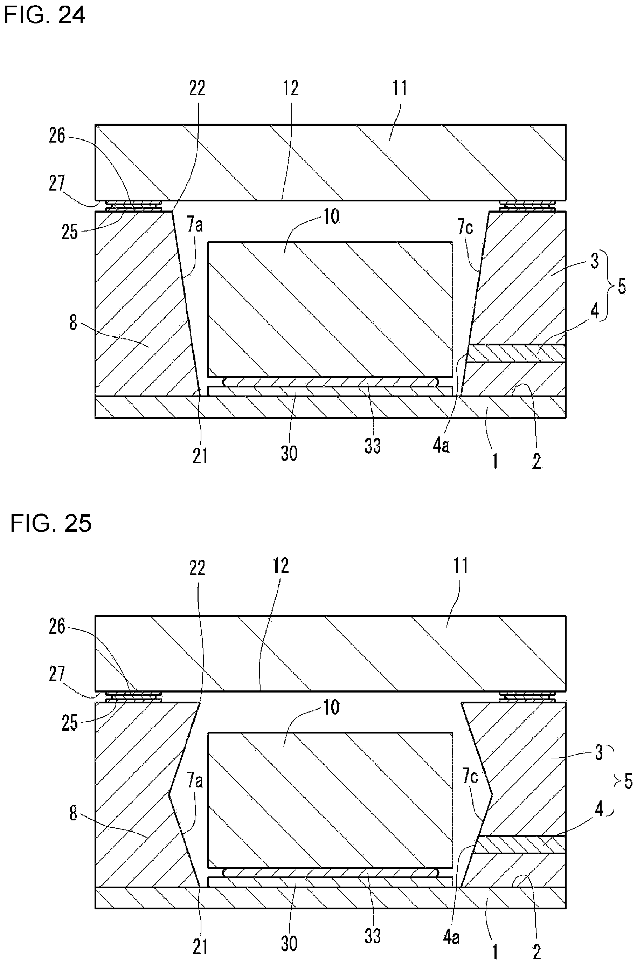

FIG. 24 shows a recess in an optical waveguide package according to a fourteenth embodiment of the present disclosure. The components corresponding to those in the above embodiments are given the same reference numerals and will not be described repeatedly. In a light-emitting device 20 according to the present embodiment, the optical waveguide layer 5 has a height greater than or equal to that of the light-emitting elements 10 and is covered with a plate-like lid 11a as in the second embodiment shown in FIG. 16.

The light-emitting device 20 with this structure includes the lid 11a with no bend, or in other words, a plate, thus reducing cracks.

### Fifteenth Embodiment

FIG. 25 shows a recess in an optical waveguide package according to a fifteenth embodiment of the present disclosure. The components corresponding to those in the above embodiments are given the same reference numerals and will not be described repeatedly. In a light-emitting device 20 according to the present embodiment, each first recess 8 has a first inner wall surface 7 having an angular recess with a corner.

In the light-emitting device 20 with this structure, the corner is located above the incident end faces 4a to 4c of the core 4 to allow any stress to concentrate on a portion other than the core 4. This structure has an internal space hexagonal in cross section, as in some of the embodiments described above. This reduces deformation of the first inner wall surfaces 7 and cracks in the lid 11a and the first inner wall surfaces 7 under thermal stress.

### Sixteenth Embodiment

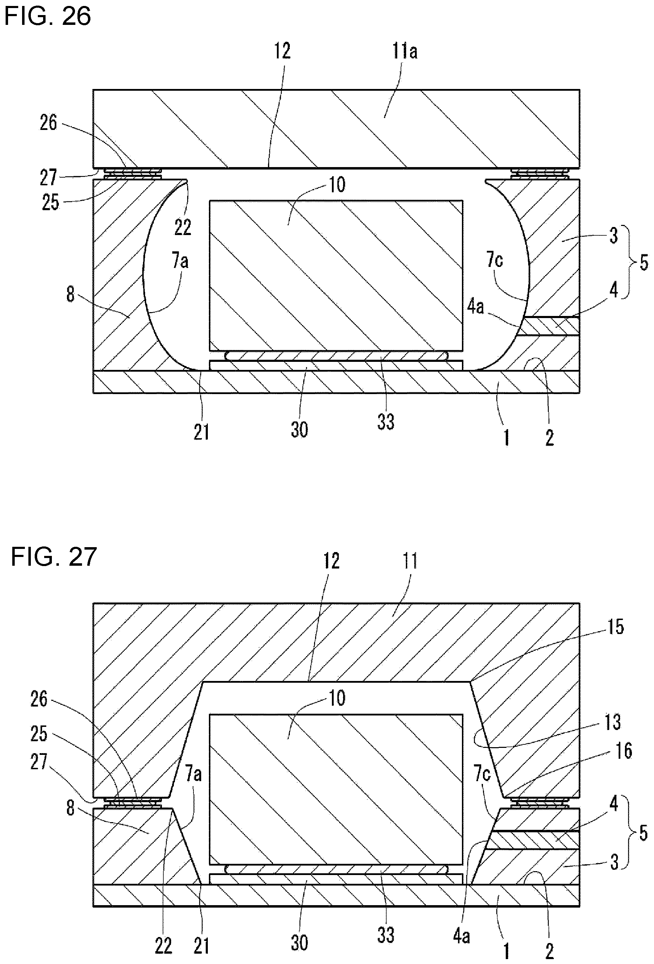

FIG. 26 shows a recess in an optical waveguide package according to a sixteenth embodiment of the present disclosure. The components corresponding to those in the above embodiments are given the same reference numerals and will not be described repeatedly. In a light-emitting device 20 according to the present embodiment, the optical waveguide layer 5 has a height greater than or equal to that of the light-emitting elements 10 and is covered with a plate-like lid 11a as in the embodiments shown in FIGs. 16 and 24. The first inner wall surfaces 7 are concave inside.

The light-emitting device 20 with this structure has an internal space with no corner in cross section, unlike a light-emitting device 20 having flat first inner wall surfaces 7. This allows distribution of stress under thermal expansion or contraction to reduce thermal stress, and thus reduces deformation and cracks in the optical waveguide layer 5 and the lid 11.

### Seventeenth Embodiment

FIG. 27 shows a recess in an optical waveguide package according to a seventeenth embodiment of the present disclosure. The components corresponding to those in the above embodiments are given the same reference numerals and will not be described repeatedly. In a light-emitting device 20 according to the present embodiment, the optical waveguide layer 5 and the lid 11 are formed from the same material. The optical waveguide layer 5 and the lid 11 may be formed from a gas barrier material, such as glass or silicon.

The light-emitting device 20 with this structure reduces the difference in thermal expansion between the optical waveguide layer 5 and the lid 11 and relaxes thermal stress. The light-emitting device 20 thus reduces damage to the lid 11, the optical waveguide layer 5, and their joint interface resulting from deformation. This also reduces misalignment of the core 4 caused by thermal expansion, thus allowing efficient optical coupling.

In still another embodiment of the present disclosure, the light-emitting elements 10 are not limited to light-emitting diodes (LEDs) but may be, for example, laser diodes (LDs) or vertical cavity surface emitting lasers (VCSELs).

Although embodiments of the present disclosure have been described in detail, the present disclosure is not limited to the embodiments described above, and may be changed or modified in various manners without departing from the spirit and scope of the present disclosure. The components described in the above embodiments may be entirely or partially combined as appropriate unless any contradiction arises.

### Reference Signs List

- 1: substrate
- 2: upper surface
- 3: cladding
- 3a: upper surface
- 4: core
- 4a, 4b, 4c: incident end face
- 5: optical waveguide layer
- 6: bottom surface
- 7: first inner wall surface
- 7a, 7b, 7c, 7d: wall surface
- 8: first recess
- 9ab, 9bc, 9cd, 9ad: corner support surface
- 10: light-emitting element
- 11: lid
- 12: top surface
- 13: second inner wall surface
- 14: second recess
- 15: upper side
- 16: lower side
- 17: second space
- 18: first space
- 20: light-emitting device
- 21: lower side
- 22: upper side
- 25: gas barrier layer
- 26: bond
- 27: first surface
- 28: second surface
- 30: connection pad
- 31: internal wiring conductor
- 32: external connection terminal
- 33: bond
- 41a, 41b, 41c: branching path
- 42: emission end face
- 43: merging portion
- 44: joined path
- 45: condenser lens
- 50: optical waveguide package

## Claims

1. An optical waveguide package, comprising:
a substrate; and
an optical waveguide layer on an upper surface of the substrate, the optical waveguide layer including a cladding and a core in the cladding,
wherein the cladding has at least one first recess having a bottom surface and a first inner wall surface surrounding the bottom surface, and
the first inner wall surface of the at least one first recess is inclined and has an upper side outward from a lower side.

2. The optical waveguide package according to claim 1, wherein
the core has an end face having a portion exposed at the first inner wall surface.

3. The optical waveguide package according to claim 1 or claim 2, wherein
the first inner wall surface is concave inside.

4. The optical waveguide package according to claim 1 or claim 2, wherein
the first inner wall surface is flat.

5. The optical waveguide package according to any one of claims 1 to 4, wherein
the first inner wall surface includes a first wall surface, a second wall surface adjacent to the first wall surface, and a corner support surface between the first wall surface and the second wall surface.

6. The optical waveguide package according to any one of claims 1 to 5, wherein
the optical waveguide layer further includes a lid located over the at least one first recess and covering an opening of the at least one first recess.

7. The optical waveguide package according to claim 6, wherein
the lid has a second recess having a top surface facing the bottom surface and a second inner wall surface surrounding the top surface, and
the second inner wall surface is inclined and has a lower side outward from an upper side.

8. The optical waveguide package according to claim 7, wherein
the second inner wall surface is concave inside.

9. The optical waveguide package according to claim 7, wherein
the second inner wall surface is flat.

10. The optical waveguide package according to any one of claims 7 to 9, wherein
the lid has a first surface outward from the lower side of the second inner wall surface, and a second surface convex inside between the first surface and the lower side of the second inner wall surface.

11. The optical waveguide package according to any one of claims 1 to 10, wherein
the at least one first recess includes a first space to accommodate a light-emitting element and a second space continuous with the first space.

12. A light-emitting device, comprising:
the optical waveguide package according to any one of claims 1 to 11; and
at least one light-emitting element accommodated in the at least one first recess in the optical waveguide package.

13. The light-emitting device according to claim 12, wherein
the at least one light-emitting element includes three light-emitting elements being a light-emitting element configured to emit red light, a light-emitting element configured to emit green light, and a light-emitting element configured to emit blue light, and
the at least one first recess includes three first recesses respectively accommodating the three light-emitting elements.
